# EUROPEAN PATENT APPLICATION

(11) **EP 4 579 644 A1**
(43) Date of publication of application: **02.07.2025**
(21) Application number: 24213862.6
(22) Date of filing: 19.11.2024
(51) Int. Cl.: G09G 3/3233

(54) **DISPLAY PANEL AND DISPLAY DEVICE INCLUDING THE SAME**

(30) Priority: 28.12.2023 KR 20230193989
(71) Applicant: LG Display Co., Ltd., Seoul 07336 (KR)
(72) Inventor: CHOI, Kwang Hyun, 10845 Paju-si (KR); KIM, Chang Soo, 10845 Paju-si (KR); KIM, Seong Yeong, 10845 Paju-si (KR)
(74) Representative: Cousens, Nico

(57) **Abstract**

A display panel can include a plurality of data lines, a plurality of gate lines, a plurality of power lines, and a plurality of pixels. Also, each of the plurality of pixels can include a first light-emitting element, a second light-emitting element, a compensation part configured to supply a current to the first light-emitting element and the second light-emitting element, a switch circuit, and a mode control part. The switch circuit is configured to in response to receiving a mode selection signal, supply the current to the first light-emitting element in a first mode, and supply the current to the second light-emitting element in a second mode or to supply the current to both of the first light-emitting element and the second light-emitting element in the second mode. Also, the mode control part is configured to supply the mode selection signal to the switch circuit.

## Description

This application claims priority to Korean Patent Application No. 10-2023-0193989, filed in the Republic of Korea on December 28, 2023.

### BACKGROUND

### Field

The present disclosure relates to a display panel having a variable viewing angle on a pixel-by-pixel basis, and to a display device including the same.

### Description of the Related Art

Recently, viewing angle variable technology is being applied to display devices. The variable viewing angle technology allows video content or visual information reproduced on a display device to be selectively visible only to a user within a narrow viewing angle range, or to multiple users within a wide viewing angle range.

As the market for future vehicles such as electric vehicles and autonomous vehicles expands, the demand for in-vehicle display devices is growing rapidly. Research is being conducted on how to split the screen of an in-vehicle display device so that one portion of the screen is controlled at a narrow viewing angle and another portion is controlled at a wide viewing angle. This technology can display private content or information that only a specific user can see on pixels driven at the narrow viewing angle, while displaying shared content that multiple users can view together on the pixels driven at the wide viewing angle (e.g., to separate views for the passenger vs. the driver, and provide a wide angle view for sharing between multiple people.). Thus, there exists a need for a pixel technology that can freely control each pixel at the narrow viewing angle and the wide viewing angle on a pixel by pixel basis.

### SUMMARY OF THE DISCLOSURE

The present disclosure has been made in an effort to address aforementioned necessities and/or drawbacks associated with the related art.

The present disclosure provides a display panel capable of selecting a viewing angle on a pixel-by-pixel basis and a display device including the same.

The problems or limitations to be solved or addressed by the present disclosure are not limited to those mentioned above, and other problems or limitations not mentioned will be clearly understood by those skilled in the art from the following description.

A display panel according to one embodiment includes a display panel in which a plurality of data lines, a plurality of gate lines, a plurality of power lines, and a plurality of pixel are disposed. Each of the pixels includes a first light-emitting element, second light-emitting element, a compensation part configured to supply a current to the first light-emitting element and the second light-emitting element, a switch circuit configured to supply the current to the first light-emitting element in a first mode and the current to the second light-emitting element in a second mode, or to supply the current to the first light-emitting element and the second light-emitting element in the second mode, in response to a mode selection signal, and a mode control part configured to supply the mode selection signal to the switch circuit.

According to aspects of the present disclosure, each of the pixels can further include a plurality of sub-pixels. Each of the sub-pixels can include the first light-emitting element, the second light-emitting element, the compensation part, and the switch circuit. The switch circuit can include a first pixel switch element connected between the compensation part and the first light-emitting element and configured to be turned on/off in response to a first mode selection signal, and a second pixel switch element connected between the compensation part and the second light-emitting element and configured to be turned on/off in response to a second mode selection signal. The mode control part can output the first mode selection signal and the second mode selection signal. In the first mode, the first light-emitting element can be emitted by a current supplied through the first pixel switch element. In the second mode, the second light-emitting element can be emitted by a current supplied through the second pixel switch element.

According to aspects of the present disclosure, the mode control part can include a first switch element configured to apply the first mode selection signal to a gate electrode of the first pixel switch element in response to a scan signal, and a second switch element configured to apply the second mode selection signal to a gate electrode of the second pixel switch element in response to the scan signal.

According to aspects of the present disclosure, the first switch element can include a first electrode connected to a first control signal line to which the first mode selection signal is applied, a gate electrode to which the scan signal is applied, and a second electrode connected to a gate electrode of the first pixel switch element. The second switch element can include a first electrode connected to a second control signal line to which the second mode selection signal is applied, a gate electrode to which the scan signal is applied, and a second electrode connected to a gate electrode of the second pixel switch element.

According to aspects of the present disclosure, the mode control part can further include a first capacitor connected between a power line to which a constant voltage is applied and the second electrode of the first switch element, and a second capacitor connected between a power line to which the constant voltage is applied and the second electrode of the second switch element.

According to aspects of the present disclosure, each of the pixels can further include a plurality of sub-pixels. Each of the sub-pixels can include the first light-emitting element, the second light-emitting element, the compensation part, and the switch circuit. The switch circuit can include a pixel switch element connected between the compensation part and the second light-emitting element and configured to be turned on/off in response to a second mode selection signal. The mode control part can output the second mode selection signal. In the first mode, the first light-emitting element can be emitted by a current from the compensation part. In the second mode, the first light-emitting element can be emitted by a current from the compensation part and the second light-emitting element is emitted by a current supplied through the pixel switch element.

According to aspects of the present disclosure, the mode control part can include a switch element configured to apply the second mode selection signal to a gate electrode of the pixel switch element in response to a scan signal.

According to aspects of the present disclosure, the switch element can include a first electrode connected to a control signal line to which the second mode selection signal is applied, a gate electrode to which the scan signal is applied, and a second electrode connected to the gate electrode of the pixel switch element.

According to aspects of the present disclosure, the mode control part can further include a capacitor connected between a power line to which a constant voltage is applied and the second electrode of the switch element.

According to aspects of the present disclosure, the display panel can further include an EVDD power line configured to supply a pixel driving voltage to the compensation part, and a VDD power line configured to supply a constant voltage to the mode control part.

According to aspects of the present disclosure, the EVDD power line can include a first EVDD power line, and a second EVDD power line connected to the first EVDD power line at an intersection with the first EVDD power line. The VDD power line can be parallel to the second EVDD power line and can be separated from the first EVDD power line and the second EVDD power line with an insulating layer therebetween.

According to aspects of the present disclosure, the display panel can further include a shorting line disposed in a non-display area of the display panel, and a plurality of EVSS power lines connected to the shorting line and connected to the compensation part across a display area of the display panel. A cathode voltage can be supplied to the compensation part via the shorting line and the EVSS power lines.

According to aspects of the present disclosure, the compensation part can include a driving element including a first electrode connected to a first node, a gate electrode connected to a second node, and a second electrode connected to a third node, a first compensation switch element connected between the second node and the third node and configured to be turned on in response to a first scan signal, a second compensation switch element connected between a data line to which a data voltage is applied and the first node and configured to be turned on in response to a second scan signal, a third compensation switch element connected between a power line to which a pixel driving voltage is applied and the first node and configured to be turned on/off in response to an emission signal, a fourth compensation switch element connected between the third node and the fourth node and configured to be turned on/off in response to the emission signal, and a storage capacitor connected between a power node to which a pixel driving voltage is applied and the second node. The mode control part can include one or more switch elements configured to be turned on/off in response to the second scan signal.

According to aspects of the present disclosure, the compensation part can further include a fifth compensation switch element connected between the second node and a power line to which an initialization voltage is applied and configured to be turned on/off in response to a fourth scan signal, a sixth compensation switch element connected between a fifth node and a power line to which a first compensation voltage is applied and configured to be turned on/off in response to a third scan signal, a seventh compensation switch element connected between a sixth node and a power line to which the first compensation voltage is applied and configured to be turned on/off in response to the third scan signal, and an eighth compensation switch element connected between the first node and a power line to which a second compensation voltage is applied and configured to be turned on/off in response to the third scan signal. The switch circuit can include a first pixel switch element connected between the fourth node and the fifth node and configured to be turned onto supply a current from the driving element to the first light-emitting element in the first mode, and a second pixel switch element connected between the fourth node and the sixth node and configured to be turned on to supply a current from the driving element to the second light-emitting element in the second mode. The first light-emitting element can include an anode electrode connected to the fifth node, and a cathode electrode connected to a power line to which a cathode voltage is applied. The second light-emitting element can include an anode electrode connected to the sixth node, and a cathode electrode connected to a power line to which the cathode voltage is applied.

According to aspects of the present disclosure, the compensation part can further include a fifth compensation switch element connected between the second node and a power line to which an initialization voltage is applied and configured to be turned on/off in response to a fourth scan signal, a sixth compensation switch element connected between the fourth node and a power line to which a first compensation voltage is applied, and configured to be turned on/off in response to a third scan signal, a seventh compensation switch element connected between a fifth node and a power line to which the first compensation voltage is applied and configured to be turned on/off in response to the third scan signal, and an eighth compensation switch element connected between the first node and a power line to which a second compensation voltage is applied and configured to be turned on/off in response to the third scan signal. The switch circuit can include a pixel switch element connected between the fourth node and the fifth node and configured to be turned on to supply a current from the driving element to the second light-emitting element in the second mode. The first light-emitting element can include an anode electrode connected to the fourth node and a cathode electrode connected to a power line to which a cathode voltage is applied. The second light emitting element can include an anode electrode connected to the fifth node and a cathode electrode connected to a power line to which the cathode voltage is applied.

A display device according to one embodiment includes a display panel including a plurality of data lines, a plurality of gate lines, a plurality of power lines, and a plurality of pixels, a data driver configured to supply a data voltage to the data lines, and a gate driver configured to supply a scan signal and an emission signal to the gate lines. Each of the pixels includes a first light-emitting element, second light-emitting element, a compensation part configured to receive the data voltage, the scan signal, and the emission signal and supply a current to the first light-emitting element and a second light-emitting element, a switch circuit configured to supply the current to the first light-emitting element in a first mode and the current to the second light-emitting element in a second mode, or to supply the current to the first light-emitting element and the second light-emitting element in the second mode, in response to a mode selection signal, and a mode control part configured to supply the mode selection signal to the switch circuit in response to the scan signal.

The present disclosure can minimize circuit elements and wires to supply the mode selection signal to each pixel individually, and can control the viewing angle on a pixel-by-pixel basis.

The present disclosure can optimize the process of the display panel in which the viewing angle is adjusted on a pixel-by-pixel basis and improve yield by minimizing the number of circuit elements and wires for driving each of the pixels at the narrow viewing angle and the wide viewing angle.

The present disclosure can reduce the power consumption of the display panel and increase its lifespan.

The present disclosure can reduce the interference of a constant voltage between the compensation part and the mode control part.

The present disclosure can freely control the size and shape of the pixel area driven by the narrow viewing angle and the pixel area driven by the wide viewing angle by changing the viewing angle on a pixel-by-pixel basis.

The effects of the present disclosure are not limited to the above-mentioned effects, and other effects that are not mentioned will be apparently understood by those skilled in the art from the following description and the appended claims.

### BRIEF DESCRIPTION OF THE DRAWINGS

The above and other objects, features and advantages of the present disclosure will become more apparent to those of ordinary skill in the art by describing example embodiments thereof in detail with reference to the attached drawings, in which:
FIG. 1 is a block diagram illustrating a display device according to an embodiment of the present disclosure;
FIG. 2 is a circuit diagram illustrating a pixel according to an embodiment of the present disclosure;
FIG. 3 is a waveform diagram illustrating signals input to the mode control part shown in FIG. 2 according to an embodiment of the present disclosure;
FIG. 4 is a circuit diagram illustrating a pixel according to another embodiment of the present disclosure;
FIG. 5 is a waveform diagram illustrating signals inputted to the mode control part shown in FIG. 4 according to an embodiment of the present disclosure;
FIG. 6 is a diagram illustrating an example of lenses disposed over light-emitting elements according to an embodiment of the present disclosure;
FIG. 7 is a diagram illustrating an example in which a viewing angle is controlled on a pixel-by-pixel basis according to an embodiment of the present disclosure;
FIG. 8 is a diagram illustrating the operation of the pixel circuit shown in FIG. 2 for each pixel area shown in FIG. 7 according to an embodiment of the present disclosure;
FIG. 9 is a diagram illustrating a transmission path of a mode selection signal according to an embodiment of the present disclosure;
FIG. 10 is a circuit diagram illustrating a compensation part of a pixel circuit in detail according to an embodiment of the present disclosure;
FIGS. 11A to 11C are waveform diagrams illustrating examples of gate signals and a mode selection signal input to the pixel circuit shown in FIG. 10 according to an embodiment of the present disclosure;
FIG. 12 is a circuit diagram illustrating a compensation part of a pixel circuit in detail according to another embodiment of the present disclosure;
FIG. 13 is a waveform diagram illustrating an example of gate signals and a mode selection signal input to the pixel circuit shown in FIG. 12 according to an embodiment of the present disclosure;
FIG. 14 is a plan view illustrating an example of electrical separation of power lines between a compensation part and a mode control part of the pixel circuit according to an embodiment of the present disclosure;
FIG. 15 is a cross-sectional view illustrating power lines cut along line "I-I" in FIG. 14 according to an embodiment of the present disclosure; and
FIG. 16 is a plan view illustrating an example in which power lines to which a cathode voltage is applied and a compensation part of the pixel circuit are overlapped according to an embodiment of the present disclosure.

### DETAILED DESCRIPTION OF THE EMBODIMENTS

The advantages and features of the present disclosure and methods for accomplishing the same will be more clearly understood from embodiments described below with reference to the accompanying drawings. However, the present disclosure is not limited to the following embodiments but can be implemented in various different forms. Rather, the present embodiments will make the disclosure of the present disclosure complete and allow those skilled in the art to completely comprehend the scope of the present disclosure. The present disclosure is only defined within the scope of the accompanying claims.

The shapes, sizes, ratios, angles, numbers, and the like illustrated in the accompanying drawings for describing the embodiments of the present disclosure are merely examples, and the present disclosure is not limited thereto. Like reference numerals generally denote like elements throughout the present specification. Further, in describing the present disclosure, detailed descriptions of known related technologies can be omitted to avoid unnecessarily obscuring the subject matter of the present disclosure.

The terms such as "comprising," "including," "having," and "comprising" used herein are generally intended to allow other components to be added unless the terms are used with the term "only." Any references to singular can include plural unless expressly stated otherwise.

Components are interpreted to include an ordinary error range even if not expressly stated.

When a positional or interconnected relationship is described between two components, such as "on top of," "above," "below," "next to," "connect or couple with," "crossing," "intersecting," or the like, one or more other components can be interposed between them, unless "immediately" or "directly" is used.

When a temporal antecedent relationship is described, such as "after," "following," "next to," "before," or the like, it may not be continuous on a time base unless "immediately" or "directly" is used.

The terms "first," "second," and the like can be used to distinguish elements from each other, but the functions or structures of the components are not limited by ordinal numbers or component names in front of the components.

The following embodiments can be partially or entirely bonded to or combined with each other and can be linked and operated in technically various ways. The embodiments can be carried out independently of or in association with each other.

The pixel circuit and the gate drive circuit of the display device can include a plurality of transistors. The transistor can be implemented as a thin film transistor (TFT). The transistors can be implemented as an oxide thin film transistor (TFT) including an oxide semiconductor, a low temperature poly silicon TFT (LTPS TFT) including a low temperature poly silicon, and the like.

A transistor is a three-electrode element including a gate, a source, and a drain. The source is an electrode that supplies carriers to the transistor. In the transistor, carriers start to flow from the source. The drain is an electrode through which carriers exit from the transistor. In a transistor, carriers flow from a source to a drain. In the situation of an n-channel transistor, since carriers are electrons, a source voltage is a voltage lower than a drain voltage such that electrons can flow from a source to a drain. The n-channel transistor has a direction of a current flowing from the drain to the source. In the situation of a p-channel transistor (p-channel metal-oxide semiconductor (PMOS)), since carriers are holes, a source voltage is higher than a drain voltage such that holes can flow from a source to a drain. In the p-channel transistor, since holes flow from the source to the drain, current flows from the source to the drain. It should be noted that a source and a drain of a transistor are not fixed. For example, a source and a drain can be changed according to an applied voltage. Therefore, the disclosure is not limited to a source and a drain of a transistor. In the following description, a source and a drain of a transistor will be referred to as a first electrode and a second electrode.

A gate signal swings between a gate-on voltage and a gate-off voltage. A transistor is turned on in response to a gate-on voltage and is turned off in response to a gate-off voltage. In the situation of an n-channel transistor, the gate-on voltage can be a gate high voltage VGH, and the gate-off voltage can be a gate low voltage VGL. In the situation of a p-channel transistor, the gate-on voltage can be the gate low voltage VGL, and the gate-off voltage can be the gate high voltage VGH.

Hereinafter, various embodiments of the present disclosure will be described in detail with reference to the accompanying drawings. All the components of each display device according to all embodiments of the present disclosure are operatively coupled and configured.

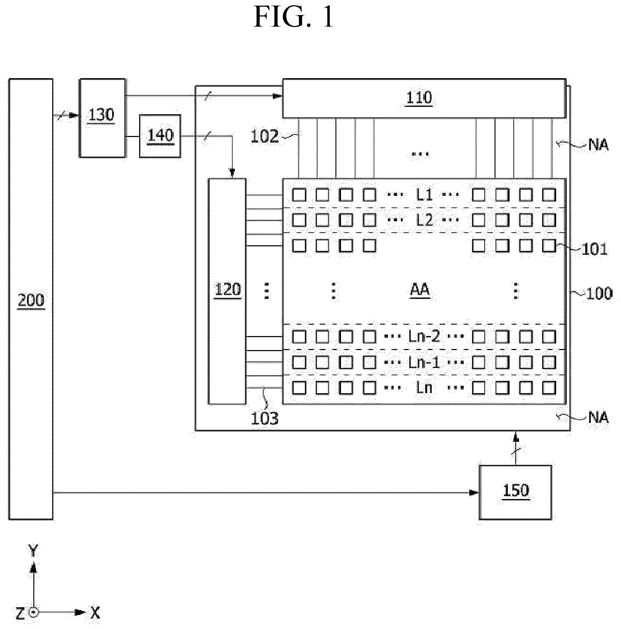

Referring to FIG. 1, a display device according to an embodiment of the present disclosure includes a display panel 100 and a display panel driving circuit for writing pixel data to pixels of the display panel 100. The display device also includes a power supply 150.

The display panel 100 can be, but is not limited to, a panel having a rectangular structure with a length in the X-axis direction, a width in the Y-axis direction, and a thickness in the Z-axis direction. For example, the display panel 100 can be a deformed panel that is at least partially curved or elliptical.

A display area (or active area) AA of the display panel 100 includes a pixel array for displaying an input image thereon. The pixel array includes a plurality of data lines 102, a plurality of gate lines 103 intersected with the data lines 102, and the pixels arranged in a matrix form. The display panel 100 can further include a plurality of power lines. The power lines are connected to constant voltage nodes of the pixel circuits and supply a constant voltage necessary for driving the pixels 101 to the pixels 101. The power lines can be implemented as striped or mesh wirings to be connected in common to the pixels 101 of the display panel 100.

The power lines can be commonly connected to pixel circuits and supply a voltage required for driving the pixels 101 to the pixels 101.

Each of the pixels 101 can be divided into a red sub-pixel, a green sub-pixel, and a blue sub-pixel for color implementation. Each of the pixels can further include a white sub-pixel. Each of the sub-pixels includes a compensation part for driving a light-emitting element. Each of the pixels 101 can further include a mode control part to control a viewing angle. The light-emitting element can be a light-emitting element, such as an organic light emitting diode (OLED) or a micro light-emitting diode (LED). Hereinafter, the pixel can be interpreted as the sub-pixel.

Each of the sub-pixel can include one or more first light-emitting elements that are emitted in a first mode and a second light-emitting element that is emitted in a second mode. Each of the pixels 101 emits light from a first light-emitting element at a wide viewing angle in the first mode (e.g., wide viewing angle mode, public viewing mode, or shared viewing mode), while emitting light from the second light-emitting element at a narrow viewing angle in the second mode (e.g., narrow viewing mode, privacy viewing mode, or safety viewing mode).

The display array AA includes a plurality of pixel lines L1 to Ln, where n is a natural number such as an integer greater than 1. Each of the pixel lines L1 to Ln includes one line of pixels arranged along the line direction (e.g., X-axis direction) in the pixel array of the display panel 100. The pixels 101 arranged in one pixel line can share the gate lines 103. The sub-pixels arranged along the column direction (e.g., Y direction) can share the same data line 102. One horizontal period is a time obtained by dividing one frame period by the total number of the pixel lines L1 to Ln.

The display panel 100 can be implemented as a non-transmissive display panel or a transmissive display panel. The transmissive display panel can be applied to a transparent display device in which an image is displayed on a screen and an actual object is visible beyond the display panel. The display panel 100 can be made as a flexible display panel that can be flexibly bent.

The power supply 150 receives an input voltage from a host system 200 and outputs voltages required to drive the pixels 101 of the display panel 100 and the display panel driving circuit. To this end, the power supply 150 can include a direct current to direct current converter (DC-DC converter). The DC-DC converter can include a charge pump, a regulator, a buck converter, a boost converter, and the like. The power supply 150 can output constant voltages (or direct current voltages), such as a gate-high voltage, a gate-low voltage, a pixel driving voltage, a cathode voltage, an initialization voltage, a first compensation voltage, a second compensation voltage, and an IC driving voltage for the display panel driving circuit through the DC-DC converter. The gate-high voltage and the gate-low voltage can be supplied to a level shifter 140 and the gate driver 120. The voltages such as the pixel driving voltage, the cathode voltage, the initialization voltage, the first compensation voltage, and the second compensation voltage are supplied to the pixels 101 via the power lines commonly connected to the pixels 101.

The power supply 150 can further include a gamma voltage generator. The gamma voltage generator receives a high potential reference voltage and a low potential reference voltage and outputs a plurality of gamma reference voltages divided by a predetermined voltage interval on a preset gamma curve, e.g., 2.2 gamma curve. The gamma reference voltages are supplied to the data driver 110. In the data driver 110, the gamma reference voltages are divided by a voltage division circuit and subdivided into grayscale voltages. The gamma voltage generator can be implemented as a programmable gamma circuit capable of adjusting each of the gamma reference voltages according to digital data. A timing controller 130 or the host system 200 or a separate external device can update digital data stored in a register of the programmable gamma circuit through a communication interface.

The display panel driving circuit writes the pixel data of the input image to the pixels 101 of the display panel 100 under the control of the timing controller 130. The display panel driving circuit includes the data driver 110 and the gate driver 120.

The display panel driving circuit can further include a touch sensor driver for driving touch sensors. The data driver 110 and the touch sensor driver can be integrated into a source drive integrated circuit (IC).

The data driver 110 receives the pixel data of the input image received as a digital signal from the timing controller 130 and outputs the data voltage. The input image can be image data including various contents such as private content, shared content, and the like. The data driver 110 can receive the gamma reference voltages and generate gamma compensated voltages for each grayscale through the voltage division circuit. A gamma-compensated voltage for each grayscale is supplied to a digital to analog converter ("DAC") disposed on each of the channels of the data driver 110.

The data driver 110 samples and latches the digital data received from the timing controller 130, and then inputs the digital data to the DAC. Here, the digital data includes pixel data of the input image. The DAC converts the pixel data to a gamma-compensated voltage and outputs the data voltage of the pixel data.

The gate driver 120 can be formed on the display panel 100 together with circuit elements of the display area AA and the wires. The gate driver 120 can be disposed in at least one of left and right non-display areas (or non-active areas) NA of the display panel 100 outside the display area AA, or at least a portion thereof can be disposed within the display area AA.

The gate driver 120 can be disposed in the non-display areas NA on both sides of the display panel 100 with the display area AA of the display panel 100 interposed therebetween, and can supply gate pulses from opposite sides of the gate lines 103 in a double feeding method. In another embodiment, the gate driver 120 can be disposed in at least one of the left and right non-display areas NA of the display panel 100 to supply gate signals to the gate lines 103 in a single feeding method. The gate driver 120 sequentially outputs pulses of the gate signals to the gate lines 103 under the control of the timing controller 130. The gate driver 120 can sequentially supply the gate signals to the gate lines 103 by shifting the pulses of the gate signals using a shift register and an edge trigger. When a plurality of gate signals are applied to each of the pixels, the gate driver 120 can include a plurality of shift registers. The gate signals can include a scan signal input to the pixel circuit via a plurality of gate lines, and an emission signal (hereinafter referred to as an "EM signal").

The timing controller 130 receives from the host system 200 digital video data of the input image and a timing signal synchronized with this data. The timing signal can include a vertical synchronization signal Vsync, a horizontal synchronization signal Hsync, and a data enable signal DE. Since a vertical period and a horizontal period can be known by counting the data enable signal DE, the vertical synchronization signal Vsync and the horizontal synchronization signal Hsync can be omitted. The horizontal synchronization signal Hsync and the data enable signal DE have a period of one horizontal period (1H).

The timing controller 130 generates a data timing control signal for controlling the operation timing of the data driver 110, a gate timing control signal for controlling the operation timing of the gate driver 120, and a mode selection signal to control the viewing angle mode of each of the pixels 101, based on the timing signals Vsync, Hsync, and DE received from the host system 200, thereby controlling the pixels 101 and the display panel driving circuit. The timing controller 130 synchronizes the data driver 110 and the gate driver 120 by controlling the operation timing of the display panel driving circuit.

The timing control signal output from the timing controller 130 can be input to the shift register of the gate driver 120 through the level shifter 140. The level shifter 140 can convert a voltage level of the gate timing signal received from the timing controller 130 to a swing width between the gate-high voltage and the gate-low voltage and supply it to the gate driver 120.

The mode selection signal output from the timing controller 130 can be input to the level shifter 140. The level shifter 140 converts the mode selection signal received from the timing controller 130 to a first mode selection signal and a second mode selection signal having the swing width between the gate-high voltage and the gate-low voltage and outputs them.

The display panel driving circuit can be driven at a variable refresh rate (VRR) under the control of the timing controller 130 or the host system 200. For example, the timing controller 130 can reduce power consumption of the display device by analyzing the input image and lowering the refresh rate when the input image does not change by a preset amount of time. For example, the display panel driving circuit can lower the refresh rate of the pixels P to control a data writing period of the pixels P to be longer when a still image is input for a certain period of time or more under the control of the timing controller 130, thereby reducing the power consumption of the display device. The driving circuit for the display panel 100 can reduce the refresh rate when the display device is operated in standby mode or in response to a user command. In addition, the refresh rate can be lowered on an always on display (AOD) screen. The AOD screen is a small area of pixels in the display area AA in which preset information, e.g., brief information such as remaining battery power, time, and the like are displayed in the standby mode.

The host system 200 can scale an image signal from a video source to match the resolution of the display panel 100, and can transmit the scaled image signal to the timing controller 130 together with the timing signal. The host system 200 can transmit a mode signal having different logic values in the first mode and the second mode together with the image signal to the timing controller 130 at least once every frame. The timing controller 130 can output a mode selection signal to select a first mode or a second mode in response to the mode signal from the host system 200.

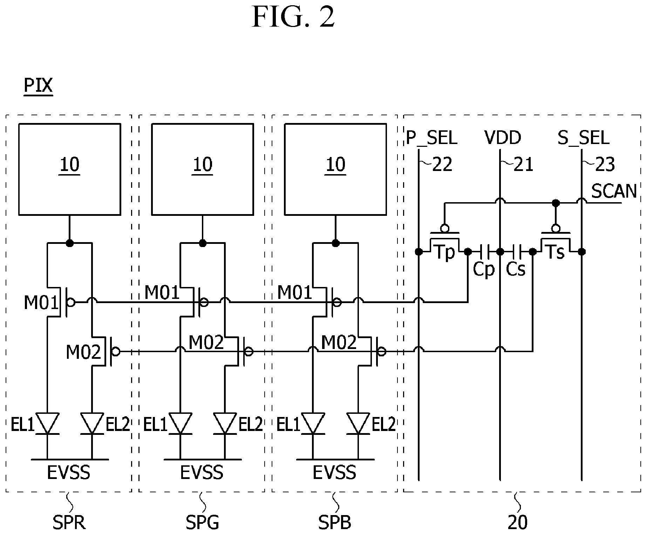

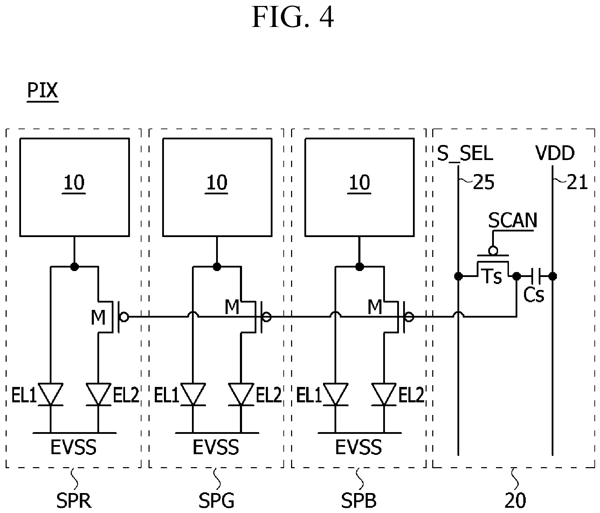

As shown in FIGS. 2 and 4, each of the pixels 101 can include a compensation part for supplying a current to a first light-emitting element and a second light-emitting element, a switch circuit for supplying the current to the first light-emitting element in the first mode and the current to the second light-emitting element in the second mode, in response to the mode selection signal, and a mode control part for controlling the switch circuit by supplying the mode selection signal to the switch circuit.

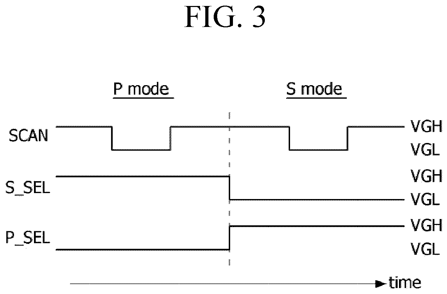

FIG. 2 is a circuit diagram illustrating pixels according to one embodiment of the present disclosure. FIG. 3 is a waveform diagram illustrating signals input to the mode control part shown in FIG. 2.

Referring to FIGS. 2 and 3, each of the pixels PIX of the display panel 100 includes a first sub-pixel SPR, a second sub-pixel SPG, a third sub-pixel SPB, and a mode control part 20. The first sub-pixel SPR can be a red sub-pixel that emits light of red wavelengths with the luminance corresponding to the grayscale of the first pixel data. The second sub-pixel SPG can be a green sub-pixel that emits light of green wavelengths with the luminance corresponding to the grayscale of the second pixel data. The third sub-pixel SPB can be a blue sub-pixel that emits light of blue wavelengths with the luminance corresponding to the grayscale of the third pixel data.

The pixel circuit of each of the sub-pixels SPR, SPG, and SPB includes a first light-emitting element EL1 that emit light in the first mode (e.g., P mode), a second light-emitting element EL2 that emit light in a second mode (e.g., S mode), a compensation part 10 generating a current necessary to drive the first and second light-emitting elements EL1 and EL2, and a switch circuit. The switch circuit includes a first pixel switch element M01 that switches a current path between the compensation part 10 and the first light-emitting element EL1, and a second pixel switch element M02 that switches a current path between the compensation part 10 and the second light-emitting element EL2.

The mode control part 20 includes a first switch element Tp, a second switch element Ts, a first mode capacitor Cp, and a second mode capacitor Cs. The mode control part 20 can also be referred to as a mode controller, a mode selector, or a mode selector circuit, but embodiments are not limited thereto.

The switch elements M01, M02, Tp, and Ts can be implemented as, but are not limited to, p-channel transistors. A gate-on voltage of a p-channel transistor is a gate-low voltage VGL, and a gate-off voltage thereof is a gate-high voltage VGH.

The compensation part 10 receives the data voltage of the pixel data, the scan signal, the EM signal, and the pixel driving voltage, and generates a current to drive the light-emitting elements EL1 and EL2. The compensation part 10 can be connected to the data lines, the gate lines, and the power lines.

The first light-emitting element EL 1 is connected between the first pixel switch element M01 and an EVSS node to which a cathode voltage EVSS is applied, and is driven by the current applied from the compensation part 10 through the first pixel switch element M01 in the first mode (e.g., P mode) to emit light. The first light-emitting element EL1 includes an anode electrode connected to the first pixel switch element M01, and a cathode electrode to which the cathode voltage VSS is applied.

The second light-emitting element EL2 is connected between the second pixel switch element M02 and the EVSS node, and is driven by the current applied from the compensation part 10 through the second pixel switch element M02 in the second mode (e.g., S mode) to emit light. The second light-emitting element EL2 includes an anode electrode connected to the second pixel switch element M02, and a cathode electrode connected to the EVSS node.

The first pixel switch element M01 is connected between the compensation part 10 and the first light-emitting element EL1, and is turned on in response to the gate-low voltage VGL of a first mode selection signal P_SEL. When the first pixel switch element M01 is turned on, a current path is formed between the compensation part 10 and the first light-emitting element EL1 so that the first light emitting element EL1 can be emitted. The first pixel switch element M01 is turned on when the voltage of the first mode selection signal P_SEL is the gate-low voltage VGL. The first pixel switch element M01 includes a first electrode connected to the compensation part 10, a gate electrode to which the first mode selection signal P_SEL is applied, and a second electrode connected to the anode electrode of the first light emitting element EL 1.

The second pixel switch element M02 is connected between the compensation unit 10 and the second light-emitting element EL2, and is turned on in response to the gate-low voltage VGL of a second mode selection signal S_SEL. When the second pixel switch element M02 is turned on, a current path is formed between the compensation part 10 and the second light-emitting element EL2 so that the second light-emitting element EL2 can be emitted. The second pixel switch element M02 is turned on when the voltage of the second mode selection signal S_SEL is the gate-low voltage VGL. The second pixel switch element M02 includes a first electrode connected to the compensation part 10, a gate electrode to which the second mode selection signal S_SEL is applied, and a second electrode connected to the anode electrode of the second light-emitting element EL2.

The mode control part 20 (e.g., mode controller, mode selector, mode selector circuit) is synchronized with the compensation part 10 and controls the first pixel switch element M01 or the second pixel switch element M02 according to the selected mode when a current is generated from the compensation part 10. The mode control part 20 controls the on/off of the first pixel switch element M01 with the first mode selection signal P_SEL, and controls the on/off of the second pixel switch element M02 with the second mode selection signal S_SEL. Under the control of the mode control part 20, the first light-emitting element EL1 can be emitted in the first mode (e.g., P mode, or privacy viewing mode having a narrow viewing angle), while the second light-emitting element EL2 can be emitted in the second mode (e.g., S mode, or share viewing mode having a wide angle).

The first switch element Tp is connected between a first control signal line 22, to which the first mode selection signal P_SEL is applied, and the gate electrode of the first pixel switch element M01, and is turned on in response to the gate-low voltage VGL of a scan signal SCAN. When the first switch element Tp is turned on, the first mode selection signal P_SEL is applied to the gate electrode of the first pixel switch element M01. Therefore, the first switch element Tp controls the sub-pixels SPR, SPG, and SPB of the pixel PIX in the first mode (e.g., P mode) when the voltage of the first mode selection signal P_SEL is the gate-low voltage VGL. The first switch element Tp includes a first electrode connected to a first control signal line 22, a gate electrode connected to a gate line to which a scan signal SCAN is applied, and a second electrode connected to the gate electrode of the first pixel switch element M01 and the first mode capacitor Cp.

The second switch element Ts is connected between a second control signal line 23, to which the second mode selection signal S_SEL is applied, and the gate electrode of the second pixel switch element M02, and is turned on in response to the gate-low voltage VGL of the scan signal SCAN. When the second switch element Ts is turned on, the second mode selection signal S_SEL is applied to the gate electrode of the second pixel switch element M02. Therefore, when the voltage of the second mode selection signal S_SEL is the gate-low voltage VGL, the second switch element Ts controls the sub-pixels SPR, SPG, and SPB of the pixel PIX in the second mode (e.g., S mode). The second switch element Ts includes a first electrode connected to the second control signal line 23, a gate electrode connected to the gate line to which the scan signal SCAN is applied, and a second electrode connected to the gate electrode of the second pixel switch element M02 and the second mode capacitor Cs.

The first mode capacitor Cp charges the voltage of the first mode selection signal P_SEL and holds it for one frame period. A first electrode of the first mode capacitor Cp is connected to the second electrode of the first switch element Tp, and to the gate electrode of the first pixel switch element M01. A second electrode of the first mode capacitor Cp is connected to a power line 21 to which a constant voltage VDD is applied. The second mode capacitor Cs charges the voltage of the second mode selection signal S_SEL and holds it for one frame period. A first electrode of the second mode capacitor Cs is connected to the second electrode of the second switch element Ts, and to the gate electrode of the second pixel switch element M02. A second electrode of the second mode capacitor Cs is connected to the power line 21 to which the constant voltage VDD is applied. The constant voltage VDD can be output from the power supply 150. The constant voltage VDD is not limited to the constant voltage having a specific voltage level. For example, the constant voltage VDD can be replaced with a constant voltage such as the pixel driving voltage, the initialization voltage, the first compensation voltage, the second compensation voltage, and the like.

In other words, a unit pixel can include three subpixels (e.g., red, green and blue), and each of those subpixels can have two light emitting elements, such as a light emitting element for providing a wide angle view and a light emitting element for providing a narrow angle view. Also, each of the six light emitting elements within the unit pixel can be controlled from the mode control part 20 for activation. For example, one scan signal SCAN and two mode selection signals (e.g., P_SEL and S_SEL) can be used to selectively activate the six different light emitting elements.

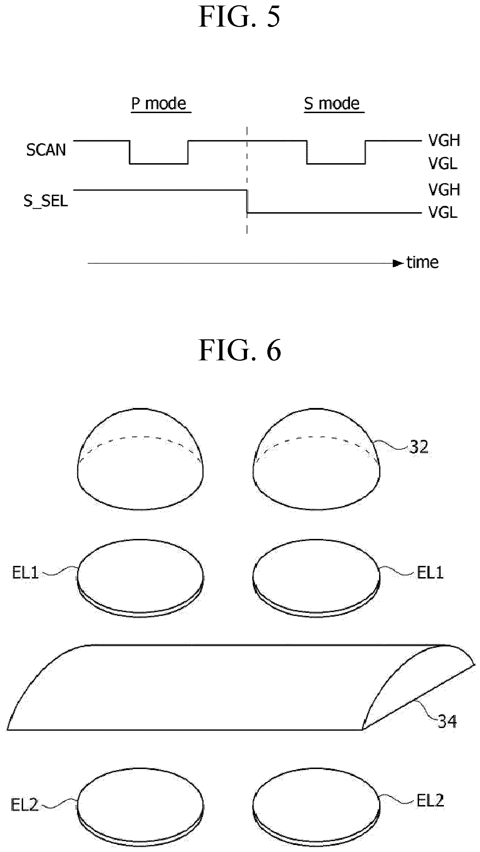

FIG. 4 is a circuit diagram illustrating a pixel according to another embodiment of the present disclosure. FIG. 5 is a waveform diagram illustrating the signals input to the mode control part shown in FIG. 4. In this embodiment, components that are substantially the same as in the preceding embodiments are designated with the same reference numerals and are not described in detail. In this embodiment, a default mode is set as the first mode (e.g., P mode, or privacy viewing mode having a narrow viewing angle). The first light-emitting element EL1 is emitted when operated in the first mode (e.g., P mode), and the first and second light-emitting elements EL1 and EL2 are emitted simultaneously when operated in the second mode (e.g., S mode, or share viewing mode having a wide angle). When the first and second light-emitting elements EL1 and EL2 are emitted simultaneously, the current density is reduced compared to the current density flowing through one light-emitting element EL1 in a situation in which only the first emitting elements EL1 is emitted, thereby delaying the deterioration of the light-emitting elements EL1 and EL2 and increasing the lifespan of the display device. Also, the amount of wiring for the circuit can be reduced, which can save space and materials, and provide a smaller footprint.

Referring to FIGS. 4 and 5, the switch circuit includes a pixel switch element M. The mode control part 20 includes a switch element Ts and a mode capacitor Cs. In the pixel circuit of this embodiment, some switch elements are omitted, resulting in a simpler circuit configuration than that shown in FIG. 2.

The mode control part 20 is synchronized with the compensation part 10 to control the pixel switch element M by applying the second mode selection signal S_SEL to the gate electrode of the pixel switch element M when a current is generated from the compensation part 10. Under the control of the mode control part 20, the first and second light-emitting elements EL1 and EL2 can be emitted in the second mode (e.g., S mode).

The switch element Ts is connected between a control signal line 25, to which the mode selection signal S_SEL is applied, and the gate electrode of the pixel switch element M, and is turned on in response to the gate-low voltage VGL of the scan signal SCAN. When the switch element Ts is turned on, the mode selection signal S_SEL is applied to the gate electrode of the pixel switch element M. Therefore, when the voltage of the mode selection signal S_SEL is the gate-low voltage VGL, the second switch element Ts controls the sub-pixels SPR, SPG, and SPB of the pixel PIX in the second mode (e.g., S mode). The switch element Ts includes a first electrode connected to the control signal line 25, a gate electrode connected to a gate line to which the scan signal SCAN is applied, and a second electrode connected to the gate electrode of the pixel switch element M and the mode capacitor Cs.

The mode capacitor Cs charges the voltage of the mode selection signal S_SEL and holds it for one frame period. The first electrode of the mode capacitor Cs is connected to the second electrode of the switch element Ts, and to the gate electrode of the pixel switch element M. A second electrode of the second mode capacitor Cs is connected to the power line 21 to which the constant voltage VDD is applied.

The pixel switch element M is turned on in response to the gate-low voltage VGL of the mode selection signal S_SEL. When the pixel switch element M is turned on, the second light-emitting element EL2 can be emitted. When the voltage of the mode selection signal S_SEL is the gate-high voltage VGH, the pixel switch element M is turned off to block a current path between the compensation part 10 and the second light-emitting element EL2, so that the second light-emitting element EL2 does not emit light. The pixel switch element M includes a first electrode connected to the compensation part 10, a gate electrode to which the second mode selection signal S_SEL is applied, and a second electrode connected to the anode electrode of the second light emitting element EL2.

FIG. 6 is a diagram illustrating an example of lenses disposed over light-emitting elements.

Referring to FIG. 6, a first lens 32 can be disposed over the first light-emitting element EL1. The second lens 32 can be a hemispherical lens or a domed shape lens, which is thicker in the center and becomes thinner toward an edge. The first lens 32 condenses light from the first light-emitting element EL1, which is emitted in the first mode (e.g., the P mode).

A second lens 34 can be disposed over the second light-emitting element EL2. The second lens 34 can be implemented as a semi-cylindrical lens to limit a vertical viewing angle while increasing a horizontal viewing angle. The second lens 34 is long in the left-to-right direction (or X-axis direction) of the display panel 100 and is narrow or short in the up-down direction (Y-axis direction).

The first and second lenses 32 and 34 can be implemented as, but are not limited to, a transparent medium or a transparent insulating layer pattern disposed within the display panel 100. The first and second lenses 32 and 34 can implement the viewing angles of the pixels PIX in the first mode (e.g., P mode or privacy viewing mode) and the second mode (e.g., S mode or share viewing mode) as the narrow viewing angle and the wide viewing angle, respectively. In a vehicle, the first and second lenses 32 and 34 can limit the vertical viewing angle of the pixel PIX to prevent light from the pixels from being reflected from a windshield screen of the vehicle to be visible, which can improve driver safety. In this way, a passenger seated next to the driver can comfortably watch or view content while in the P mode (e.g., privacy view mode) without disturbing the driver, since it can display content with a narrow viewing angle.

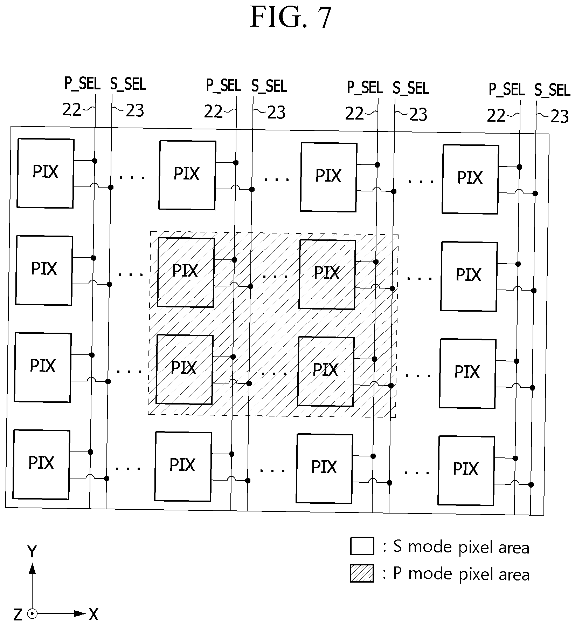

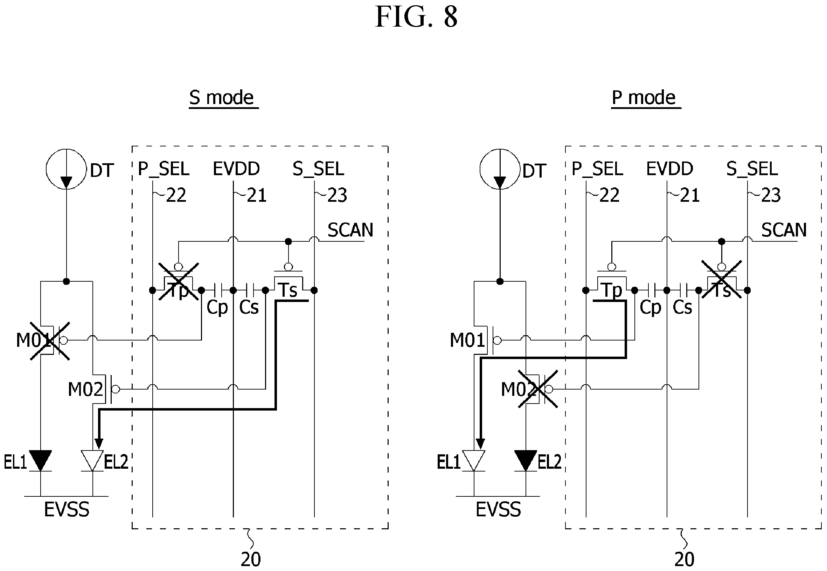

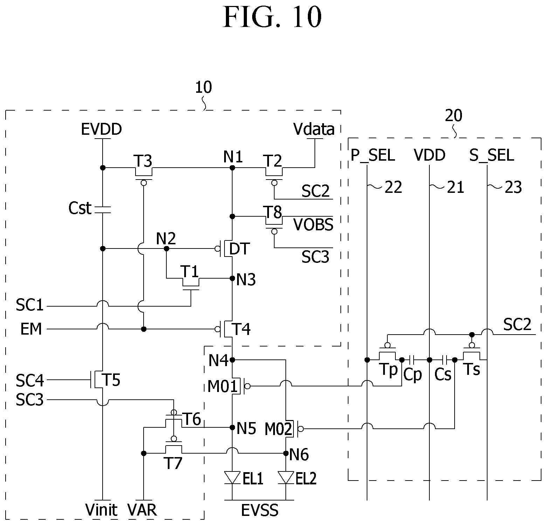

FIG. 7 is a diagram illustrating an example in which a viewing angle is controlled on a pixel-by-pixel basis. In FIG. 7, a "P mode pixel area" refers to a first pixel area in the form of a window or pop-up window that is driven in the first mode (e.g., P mode) within the display area AA. An "S mode pixel area" refers to a second pixel area that is driven in the second mode (e.g., S mode) within the display area AA. FIG. 8 is a diagram illustrating the operation of the pixel circuit shown in FIG. 2 for each pixel area shown in FIG. 7. In FIG. 8, "DT" denotes a driving element used as a constant current source. In one example of the driving element, the driving element DT can be implemented as a transistor to which a pixel driving voltage EVDD is applied, as shown in FIG. 10.

Referring to FIGS. 7 and 8, each of the pixels PIX can be driven in the first mode (e.g., P mode) or the second mode (e.g., S mode) by the mode control part 20. Therefore, within the display area AA, only a localized area in which images or private contents requiring privacy protection are displayed can be displayed at the narrow viewing angle. For example, in this way, a driver and a passenger can both share and view wide viewing angle content on a same screen, but a small portion of the screen can be activated within the second mode (e.g., S mode) in an area of the screen that is in front of the passenger to provide sensitive information with a narrow viewing angle, such as personal notifications, or to provide information that is only relevant to the passenger in order to not distract the driver, but embodiments are not limited thereto. For example, the screen can be any type of display device, such as a TV, monitor, smart phone, tablet, etc. In this way, a user can be viewing their phone while in public in which most content is displayed in the first mode (e.g., P mode) with a wide viewing angle, but the user can select certain types of sensitive information to only be displayed on a small portion or selective portion of the screen according to the second mode (e.g., S mode) with a narrow viewing angle, such as personal messages or other notifications, etc. In this way, a user can privately view sensitive information while preventing other nearby people from seeing such information (e.g., coworkers, strangers, etc.). For example, since each individual pixel can be selectively controlled to operate in the first mode (e.g., P mode) and the second mode (e.g., S mode) on a pixel by pixel basis, a user can have the freedom to selectively designate any specific area on the screen as a type of "secret" display area or "special" display area for displaying sensitive information in a narrow viewing angle mode, while the rest of the screen can operate in a wide viewing angle mode.

Also, a shared screen can be used by two or more video game players and different portions of the screen can be operated in the first mode (e.g., P mode) or the second mode the second mode (e.g., S mode) so that some content can be seen by all players while also provided specific content to individual players, etc.

The pixels PIX in the first pixel area can be driven in the first mode (e.g., P mode). In these pixels PIX, as shown in FIG. 8, the first switch element Tp and the first pixel switch element M01 can be turned on to allow the first light-emitting element EL1 to emit at the narrow viewing angle.

The pixels PIX in the second pixel area can be driven in the second mode (e.g., S mode). In these pixels PIX, as shown in FIG. 8, the second switch element Ts and the second pixel switch element M02 can be turned on to allow the second light-emitting element EL2 to emit at the wide viewing angle.

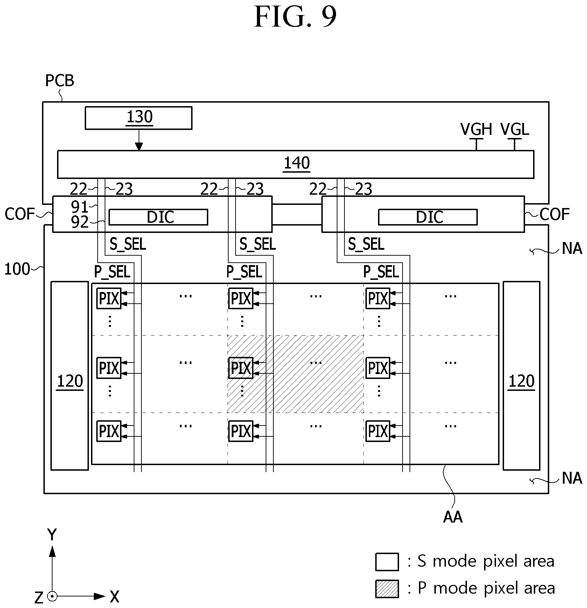

FIG. 9 is a diagram illustrating a transmission path of the mode selection signal. The pixel shown in FIG. 9 is the pixel shown in FIG. 2. In the situation of the pixel shown in FIG. 4, the control signal lines can be reduced to one.

Referring to FIG. 9, the display panel 100 can include a plurality of control signal lines 22 and 23.

The control signal lines 22 and 23 can be implemented as metallic wires in the Y-axis direction parallel to the data lines. Each of the control signal lines 22 and 23 can be connected to pixels PIX disposed along the column direction (y-axis direction) parallel to the data lines.

A display device can include a circuit board (PCB) and a chip on film (COF) electrically connected to the display panel 100. The source drive IC DIC in which the circuit of the data driver 110 is integrated can be mounted on a flexible film of the COF.

The control board PCB can include the timing controller 130, the level shifter 140, and the power supply 150. The circuit board PCB can be electrically connected to the COF.

The COF can connected between the circuit board PCB and the display panel 100 to electrically connect the circuit board PCB to the display panel 100 and to supply the data voltage output from the source drive IC DIC to the data lines on the display panel 100.

A gate timing control signal and a mode selection signal output from the timing controller 130 can be provided to the level shifter 140. The level shifter 140 receives signals from the timing controller 130, the gate-high voltage VGH, and the gate-low voltage VGL. The level shifter 140 decodes the gate timing control signal to output a start pulse and a clock that swings between the gate-high voltage VGH and the gate-low voltage VGL. The start pulse and the clock are supplied to the gate driver 120. The gate driver 120 can output pulses of the gate signal when the start pulse and the clock are input. The level shifter 140 decodes the mode selection signal and outputs the first and second mode selection signals P_SEL and S_SEL that swing between the gate-high voltage VGH and the gate-low voltage VGL. The first mode selection signal P_SEL is supplied to the pixels PIX via a first dummy wire 91 of the COF and a first control signal line 22. The second mode selection signal S_SEL is supplied to the pixels PIX via a second dummy wire 92 of the COF and a second control signal line 23. The dummy wires 91 and 92 of the COF can be disposed on either side of the flexible film and electrically connected to the control signal lines 22 and 23 of the display panel 100 without being connected to the source drive IC (DIC).

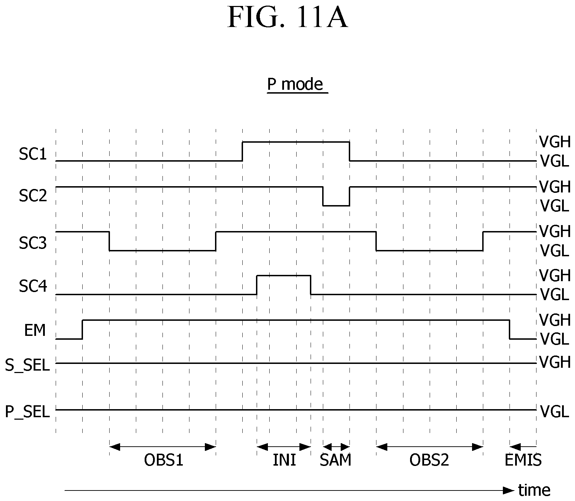

FIG. 10 is a circuit diagram illustrating a compensation part of the pixel circuit in detail according to one embodiment of the present disclosure. The compensation part shown in FIG. 10 is merely an example of a compensation part applicable to the pixel circuit of the present disclosure, and the circuit of the compensation part is not limited to one illustrated in FIG. 10. FIGS. 11A to 11C are waveform diagrams illustrating examples of gate signals and a mode selection signal input to the pixel circuit shown in FIG. 10. A mode control part 20 is substantially the same as the mode selection part shown in FIG. 2, and thus redundant description thereof is omitted or may be briefly mentioned.

Referring to FIGS 10 to 11C, the pixel circuit includes a light emitting element EL, a driving element DT for supplying a current to the light-emitting element EL, a plurality of switch elements T1 to T8, and a capacitor Cst.

Each of first and fifth compensation switch elements T1 and T5 can be implemented as an n-channel oxide TFT with low off-current characteristics or leakage current in the off-state. Except for the first and fifth compensation switch elements T1 and T5, the other compensation switch elements T2, T3, T4, T6, T7, and T8 and the driving element DT can be implemented as a p-channel LTPS TFT with good current characteristics in the on-state.

The n-channel oxide TFT is turned on in response to the gate-high voltage VGH, while it is turned off in response to the gate-low voltage VGL. The p-channel LTPS TFT can be turned on in response to the gate-low voltage VGL, while it is turned off in response to the gate-high voltage VGH.

The compensation part 10 can be connected to a data line to which a data voltage Vdata of pixel data is applied and gate lines to which gate signals SC1 to SC4 and EM are applied. The pixel circuit can be connected to power lines such as a power line to which a first compensation voltage VAR is applied, a power line to which a second compensation voltage VOBS is applied, a power line to which a pixel driving voltage EVDD is applied, a power line to which a cathode voltage EVSS is applied, and a power line to which an initialization voltage Vinit is applied. On a display panel, the power lines can be connected in common to all pixels PIX.

The pixel driving voltage EVDD and the cathode voltage EVSS can be set to voltages at which the driving element DT can operate in a saturation region. The pixel driving voltage EVDD can be set to a voltage between 2V and 3V, and the cathode voltage EVSS can be set to a voltage between -8V and -10V, but are not limited thereto. The gate-high voltage VGH can be set to a voltage higher than the pixel driving voltage EVDD, and the gate-low voltage VGL can be set to a voltage lower than the cathode voltage EVSS, but are not limited thereto.

The first compensation voltage VAR can be a voltage between -4 V and -8 V, but is not limited thereto. The first compensation voltage VAR can initialize anode electrodes of the light-emitting elements EL1 and EL2. When the driving frequencies of the pixels are changed by applying a variable refresh rate VRR, the first compensation voltage VAR can reduce the visibility to a change in luminance of the pixels. The first compensation voltage VAR can be interpreted as an anode reset voltage or an initialization voltage.

The second compensation voltage VOBS can be a voltage between 4V and 8V, but is not limited thereto. The second compensation voltage VOBS can increase the gate-source voltage of the driving element DT to change the direction of the current flowing through the channel of the driving element DT, thereby improving the hysteresis of the driving element DT. The second compensation voltage VOBS can be interpreted as an on-bias voltage.

The initialization voltage Vinit can set to, but is not limited to, a voltage lower than a lower limit of the data voltage Vdata and higher than the cathode voltage EVSS. For example, when the data voltage Vdata has a lower limit voltage of 2V and the cathode voltage EVSS is -9V, the initialization voltage Vinit can be set to a voltage between -5V and -7V The data voltage Vdata can have a dynamic range between 2V and 6V Within this dynamic range, the voltage level of the data voltage Vdata can be selected depending on a grayscale value of the pixel data.

The gate signals SC1 to SC4 and EM can provide pulses that swing between the gate-high voltage VGH and the gate-low voltage VGL. The gate signals SC1 to SC4 and EM can provide a first scan signal SC1, a second scan signal SC2, a third scan signal SC3, a fourth scan signal SC4, and an EM signal EM.

The driving element DT can generate a current according to the gate-to-source voltage to drive the first and second light-emitting elements EL1 and EL2. The driving element DT includes a gate electrode connected to a second node N2, a first electrode connected to a first node N1, and a second electrode connected to a third node N3. The capacitor Cst is connected between an EVDD node, to which a pixel driving voltage VDD is applied, and the second node N2. The EVDD node can be connected to a power line to which the pixel driving voltage is applied.

The first light-emitting element EL1 is emitted in the first mode (e.g., P mode) under the control of the mode control part 20. The first light-emitting element EL1 includes an anode electrode connected to a fifth node N5, and a cathode electrode to an EVSS node to which the cathode voltage EVSS is applied. The second light-emitting element EL2 is emitted in the second mode (e.g., S mode) under the control of the mode control part 20. The second light-emitting element EL2 includes an anode electrode connected to a sixth node, and a cathode electrode connected to the EVSS node. The EVSS node can be connected to a power line to which the cathode voltage is applied.

A first compensation switch element T1 is connected between the second node N2 and the third node N3. The first compensation switch element T1 is turned on in response to the gate-high voltage VGH of the first scan signal SC1. When the first compensation switch element T1 is turned on, the second node N2 can be electrically connected to the third node N3. The first compensation switch element T1 includes a gate electrode connected to a gate line to which the first scan signal SC1 is applied, a first electrode connected to the second node N2, and a second electrode connected to the third node N3.

A second compensation switch element T2 is connected between a data line to which the data voltage Vdata is applied and the first node N1. The second compensation switch element T2 is turned on in response to the gate-low voltage VGL of the second scan signal SC2. When the second compensation switch element T2 is turned on, the data line to which the data voltage Vdata of pixel data is applied can be electrically connected to the first node N1 so that the data voltage Vdata is applied to the first node N1. The second compensation switch element T2 includes a gate electrode connected to a gate line to which the second scan signal SC2 is applied, a first electrode connected to the data line to which the data voltage Vdata is applied, and a second electrode connected to the first node N1.

A third compensation switch element T3 is connected between the EVDD node and the first node N1. The third compensation switch element T3 is turned on in response to the gate-low voltage VGL of the EM signal EM. When the third compensation switch element T3 is turned on, the pixel driving voltage EVDD can be applied to the first node N1. The third compensation switch element T3 includes a gate electrode connected to a gate line to which the EM signal EM is applied, a first electrode connected to the EVDD node to which the pixel driving voltage EVDD is applied, and a second electrode connected to the first node N1.

A fourth compensation switch element T4 is connected between the third node N3 and a fourth node N4. The fourth compensation switch element T4 turns on in response to the gate-low voltage VGL of the EM signal EM to electrically connect the third node N3 to the fourth node N4. The fourth compensation switch element T4 includes a gate electrode connected to a gate line to which the EM signal EM is applied, a first electrode connected to the third node N3, and a second electrode connected to the fourth node N4.

A fifth compensation switch element T5 is connected between the second node N2 and an INI node to which the initialization voltage Vinit is applied. The fifth compensation switch element T5 is turned on in response to the gate-high voltage VGH of the fourth scan signal SC4. When the fifth compensation switch element T5 is turned on, the initialization voltage Vinit can be applied to the second node N2. The fifth compensation switch element T5 includes a gate electrode connected to a gate line to which the fourth scan signal SC4 is applied, a first electrode connected to the second node N2, and a second electrode connected to the INI node to which the initialization voltage Vinit is applied. The INI node can be connected to a power line to which the initialization voltage Vinit is applied.

A sixth compensation switch element T6 is connected between the fifth node N5 and a VAR node to which the first compensation voltage VAR is applied. The sixth compensation switch element T6 is turned on in response to the gate-low voltage VGL of the third scan signal SC3. When the sixth compensation switch element T6 is turned on, the first compensation voltage VAR can be applied to the anode electrode of the first light-emitting element EL1 connected to the fifth node N5. The sixth compensation switch element T6 includes a gate electrode connected to a gate line to which the third scan signal SC3 is applied, a first electrode connected to the fifth node N5, and a second electrode connected to the VAR node to which the first compensation voltage VAR is applied. The VAR node can be connected to a power line to which the first compensation voltage VAR is applied.

A seventh compensation switch element T7 is connected between the sixth node N6 and the VAR node. The seventh compensation switch element T7 is turned on in response to the gate-low voltage VGL of the third scan signal SC3. When the seventh compensation switch element T7 is turned on, the first compensation voltage VAR can be applied to the anode electrode of the second light-emitting element EL2 connected to the sixth node N6. The seventh compensation switch element T7 includes a gate electrode connected to the gate line to which the third scan signal SC3 is applied, a first electrode connected to the sixth node N6, and a second electrode connected to the VAR node to which the first compensation voltage VAR is applied.

An eighth compensation switch element T8 is connected between the first node N1 and an OBS node to which the second compensation voltage VOBS is applied. The eighth compensation switch element T8 is turned on in response to the gate-low voltage VGL of the third scan signal SC3. When the eighth compensation switch element T8 is turned on, the second compensation voltage VOBS can be applied to the first node N1. The eighth compensation switch element T8 includes a gate electrode connected to a gate line to which the third scan signal SC3 is applied, a first electrode connected to the first node N1, and a second electrode to which the second compensation voltage VOBS is applied.

The compensation voltages VOBS and VAR can be the voltages to compensate for the fluctuations in luminance of the pixels on the time axis when the refresh rate of the pixels is low (e.g., when in a standby mode, a power saving mode, or when displaying a static image for a longer than a predetermined among of time). When the pixels are driven at a constant high refresh rate, the compensation switch elements T6, T7, and T8, which apply compensation voltages VOBS and VAR to the pixels can be omitted.

A first pixel switch element M01 is connected between the fourth node N4 and the fifth node N5 to turn on in response to the gate-low voltage VGL of the first mode select signal P_SEL in the first mode (e.g., P Mode, narrow viewing angle mode). When the first pixel switch element M01 is turned on, the fourth node N4 can be electrically connected to the fifth node N5 so that the first light-emitting element EL1 is emitted. The first pixel switch element M01 includes a first electrode connected to the fourth node N4, a gate electrode to which the first mode selection signal P_SEL is applied, and a second electrode connected to the fifth node N5.

A second pixel switch element M02 is connected between the fourth node N4 and the sixth node N6 to turn on in response to the gate-low voltage VGL of the second mode select signal S_SEL in the second mode (e.g., S Mode, wide viewing angle mode). When the second pixel switch element M02 is turned on, the fourth node N4 can be electrically connected to the sixth node N6 so that the second light emitting element EL2 is emitted. The second pixel switch element M02 includes a first electrode connected to the fourth node N4, a gate electrode to which the second mode selection signal S_SEL is applied, and a second electrode connected to the sixth node N6.

The mode control part 20 is synchronized with the compensation part 10 and controls the first pixel switch element M01 or the second pixel switch element M02 according to the selected mode when a current is generated from the compensation part 10. For example, the second compensation switch element T2 of the compensation part 10, and the first and second switch elements Tp and Ts can be turned on simultaneously in response to the gate-low voltage VGL of the second scan signal SC2.

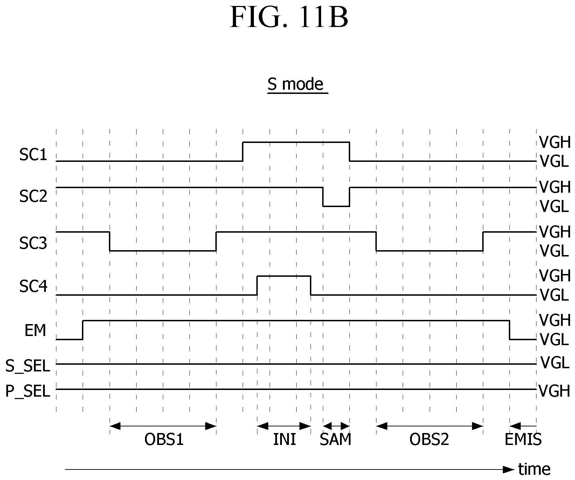

The driving period of the pixels can include a first on-bias period OBS1, an initialization period INI, a sampling period SAM, a second on-bias period OBS2, and an emission period EMIS, as shown in FIGS. 11A and 11B. A first floating period during which the switch elements T1 to T8, M01, M02, Tp, and Ts are turned off can be set between the first on-bias period OBS1 and the initialization period INI. A second floating period can be set between the sampling period SAM and the second on-bias period OBS2. A third floating period can be set between the second on-bias period OBS2 and the emission period EMIS. During the floating periods, the switch elements T1 through T8, M01, M02, Tp, Ts can be turned off to float the main nodes N1 to N6.

During the first on-bias period OBS 1, the voltage of the first, third, and fourth scan signals SC1, SC3, and SC4 can be the gate-low voltage VGL, and the voltage of the second scan signal SC2 and the EM signal EM can be the gate-high voltage VGH. During the first on-bias period OBS1, the sixth, seventh, and eighth compensation switch elements T6, T7, and T8 are turned on, allowing the second compensation voltage VOBS to be applied to the first node N1 and the first compensation voltage VAR to be applied to the fifth and sixth nodes N5 and N6.

During the first on-bias period OBS1, the first, second, third, fourth, and fifth compensation switch elements T1, T2, T3, T4, and T5 can be in the off-state. During the first on-bias period OBS1, the driving element DT can be turned on, but no current can be supplied to the light-emitting elements EL1 and EL2 because the fourth compensation switch element T4 is in the off-state. Furthermore, the light-emitting elements EL1 and EL2 do not emit light during the first on-bias period OBS1 because the voltage difference between the first compensation voltage VAR and the cathode voltage EVSS is less than the threshold voltage of the light-emitting elements EL1 and EL2.

During the initialization period INI, the voltage of the first through fourth scan signals SC1, SC2, SC3, and SC4 and the EM signal EM can be the gate-high voltage VGH. Therefore, during the initialization period INI, the first and fifth compensation switch elements T1 and T5 are turned on to apply the initialization voltage Vinit to the second and third nodes N2 and N3, and the initialization voltage Vinit can also be applied to the first node N1 via the driving element DT that maintains the on-state. During the initialization period INI, the light emitting elements EL1 and EL2 are the off-state and do not emit light.

During the initialization period INI, the voltage at the first, second, and third nodes N1, N2, and N3 can be the initialization voltage Vinit. During the initialization period INI, the fourth node N4 can be floated and maintained in its previous state because the fourth and sixth compensation switch elements T4 and T6 are in the off-state.

During the sampling period SAM, the voltage of the second scan signal SC2 is the gate-low voltage VGL that is synchronized with the data voltage Vdata of the pixel data. During the sampling period SAM, the voltages of the first and third scan signals SC1 and SC3 and the EM signal EM can be the gate-high voltage VGH, and the voltage of the fourth scan signal SC4 can be the gate-low voltage VGL. When the second compensation switch element T2 is turned on in the sampling period SAM in response to the gate-low voltage VGL of the scan pulse, the data voltage Vdata can be applied to the first node N1, and the data voltage Vdata can also be applied to the second and third nodes N2 and N3 through the driving element DT in the on-state . At the end of the sampling period SAM, the voltage at the first node N1 is the data voltage Vdata, and the voltage at each of the second and third nodes N2 and N3 is a voltage of Vdata+Vth, which is the data voltage Vdata plus the threshold voltage (Vth) of the driving element DT. During the sampling period SAM, the fourth node N4 is in a floating state and the light-emitting elements EL1 and EL2 are in the off-state and therefore not emitting.

During the second on-bias period OBS2, the voltages of the first, third, and fourth scan signals SC1, SC3, and SC4 can be the gate-low voltage VGL, and the voltages of the second scan signal SC2 and the EM signal EM can be the gate-high voltage VGH. During the second on-bias period OBS2, the sixth, seventh, and eighth compensation switch elements T6, T7, and T8 are turned on, allowing the second compensation voltage VOBS to be applied to the first node N1 and the first compensation voltage VAR to be applied to the fifth and sixth nodes N5 and N6.

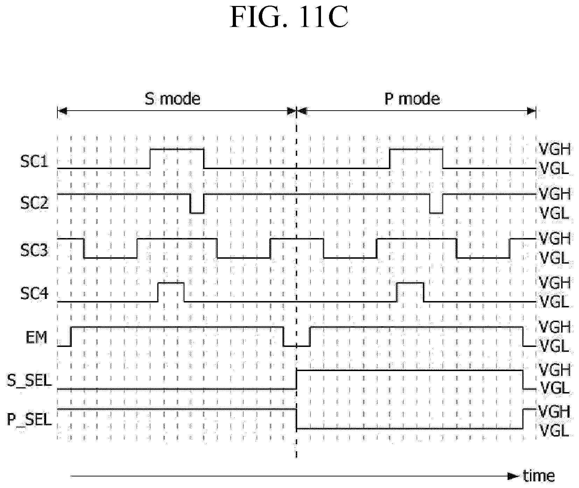

During the emission period EMIS, the voltage of the first and fourth scan signals SC1, SC4 and the EM signal EM can be the gate-low voltage VGL and the voltage of the second and third scan signals SC2 and SC3 can be the gate-high voltage VGH. During the emission interval EMIS, the third and fourth compensation switch elements T3 and T4 can be turned on in response to the gate-low voltage VGL of the EM signal EM. Therefore, during the emission period EMIS, the first light-emitting element EL1 can be emitted by the current from the driving element DT in the first mode (e.g., P mode), and the second light-emitting element EL2 can be emitted by the current from the driving element DT in the second mode (e.g., S mode). As can be seen from FIG. 11C, the first mode (e.g., P mode) and the second mode (e.g., S mode) can be determined according to the voltage levels of the mode selection signals P_SEL and S_SEL applied to the gate electrodes of the first and second pixel switch elements M01 and M02 via the mode control part 20.

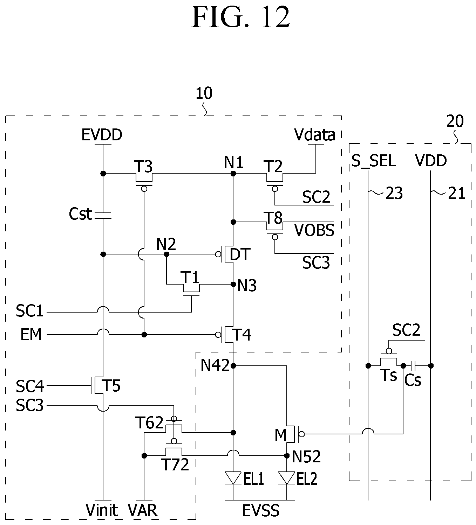

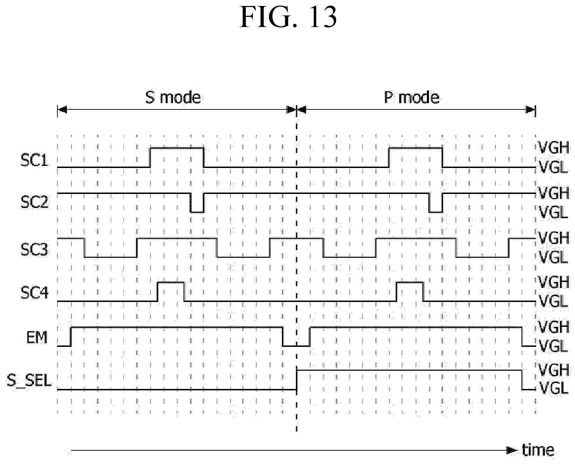

FIG. 12 is a circuit diagram illustrating a compensation part of the pixel circuit in detail according to another embodiment of the present disclosure. FIG. 13 is a waveform diagram illustrating an example of the gate signals and the mode select signal input to the pixel circuit shown in FIG. 12. In this embodiment, components that are substantially the same as the components in the pixel circuit shown in FIG. 10 will be designated with the same reference numerals and detailed descriptions will be omitted. A mode control part 20 and a first pixel switch element M are substantially the same as those shown in FIG. 4, and therefore, a redundant description thereof is omitted or may be briefly mentioned.

Referring to FIGS. 12 and 13, a driving element DT includes a gate electrode connected to a second node N2, a first electrode connected to a first node N1, and a second electrode connected to a third node N3.

A first light-emitting element EL 1 includes an anode electrode connected to a fourth node N42 and a cathode electrode connected to an EVSS node to which a cathode voltage EVSS is applied. A second light-emitting element EL2 includes an anode electrode connected to a fifth node N52 and a cathode electrode connected to the EVSS node.

A sixth compensation switch element T62 is connected between the fourth node N42 and the VAR node. The sixth compensation switch element T62 is turned on in response to the gate-low voltage VGL of the third scan signal SC3. When the sixth compensation switch element T62 is turned on, a first compensation voltage VAR can be applied to the anode electrode of the first light-emitting element EL1 connected to the fourth node N42. The sixth compensation switch element T62 includes a gate electrode to which the third scan signal SC3 is applied, a first electrode connected to the fourth node N42, and a second electrode connected to the VAR node.

A seventh compensation switch element T72 is connected between a fifth node N52 and the VAR node. The seventh compensation switch element T72 is turned on in response to the gate-low voltage VGL of the third scan signal SC3. When the seventh compensation switch element T72 is turned on, the first compensation voltage VAR can be applied to the anode electrode of the second light emitting element EL2 connected to the fifth node N52. The seventh compensation switch element T72 includes a gate electrode to which the third scan signal SC3 is applied, a first electrode connected to the fifth node N52, and a second electrode connected to the VAR node.

An eighth compensation switch element T8 is connected between the first node N1 and an OBS node to which the second compensation voltage VOBS is applied. The eighth compensation switch element T8 is turned on in response to the gate-low voltage VGL of the third scan signal SC3. When the eighth compensation switch element T8 is turned on, the second compensation voltage VOBS can be applied to the first node N1. The eighth compensation switch element T8 can include a gate electrode connected to the gate line to which the third scan signal SC3 is applied, a first electrode connected to the first node N1, and a second electrode to which the second compensation voltage VOBS is applied.

The pixel switch element M is connected between the fourth node N42 and the fifth node N52, and is turned on in response to the gate-low voltage VGL of the second mode select signal S_SEL in the second mode (e.g., S mode). When the pixel switch element M is turned on, the fourth node N42 can be electrically connected to the fifth node N52 so that the second light emitting element EL2 is emitted. The pixel switch element M includes a first electrode connected to the fourth node N42, a gate electrode to which the second mode selection signal S_SEL is applied, and a second electrode connected to the fifth node N52.

The driving period of the pixels can include a first on-bias period OBS1, an initialization period INI, a sampling period SAM, a second on-bias period OBS2, and an emission period EMIS, as shown in FIGS. 11A and 11B. As can be seen from FIG. 13, the first mode (e.g., P mode) and the second mode (e.g., S mode) can be determined according to the voltage level of the mode selection signal S_SEL applied to the gate electrode of the pixel switch element M via the mode control part 20. For example, when the pixel switch element M is turned off in response to the gate-high voltage VGH of the mode selection signal S_SEL, only the first light-emitting element EL1 can be driven during the emission period EMIS so that the pixel PIX is emitted at the narrow viewing angle. On the other hand, when the pixel switch element M is turned on in response to the gate-low voltage VGL of the mode selection signal S_SEL, the first and second light-emitting elements EL1 and EL2 can be driven during the emission period EMIS so that the pixel PIX is emitted at the wide viewing angle.

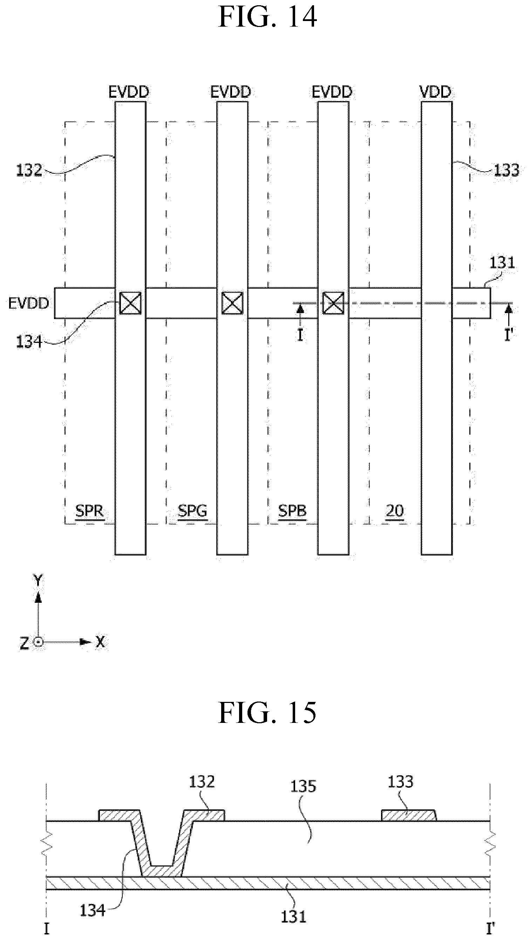

When the pixel driving voltage EVDD applied to the compensation part 10 and the constant voltage VDD applied to the mode control part 20 are electrically connected, the deviation or fluctuation in the pixel driving voltage EVDD can be reflected in the gate voltage of the pixel switch elements M, M01, and M02 as shown in FIGS. 10 and 12. To prevent this, the pixel driving voltage EVDD and the constant voltage VDD can be electrically separated from each other, as shown in FIGS. 14 and 15, which can reduce noise interference and improve image quality.

FIG. 14 is a plan view illustrating an example of electrical separation of the power lines between the compensation part and the mode control part of the pixel circuit. FIG. 15 is a cross-sectional view illustrating the power lines cut along line "I-I" in FIG. 14.

Referring to FIGS. 14 and 15, the display panel 100 can include an EVDD power line 131 and 132 supplying the pixel driving voltage EVDD to the plurality of compensation components 10, and a VDD power line 133 supplying a constant voltage VDD to a plurality of mode control parts 20.

The EVDD power lines 131 and 132 include a first EVDD power line 131 in the first direction X and a second EVDD power line 132 in the second direction Y The first EVDD power line 131 and the second EVDD power line 132 are electrically connected at an intersection therebetween. The VDD power line 133 can be disposed on the display panel 100 along the second direction Y, parallel to the second EVDD power line 132. The VDD power line 133 is separated from the EVDD power lines 131 and 132 by an insulating layer 135. The insulating layer 135 can be an inorganic or organic film, or an insulating layer in which an inorganic layer and an organic layer are stacked. Also, one or more of the EVDD power lines 131 and 132 can be disposed on a same layer as the VDD power line 133, but embodiments are not limited thereto. For example, according to an embodiment, each of the EVDD power lines 131 and 132, and the VDD power line 133 can be disposed on different layers.

The first EVDD power line 131 can overlap with circuit areas of the sub-pixels SPR, SPG, and SPB and the mode control part 20 across the sub-pixels SPR, SPG, and SPB and the mode control part 20. The second EVDD power line 132 can overlap a circuit area of the compensation unit 10 at each of the sub-pixels SPR, SPG, and SPB. The VDD power line 133 can overlap with a circuit area of the mode control part 20.

When viewed from a cross section of the display panel 100, the insulating layer 135 covers the first EVDD power line 131, as shown in FIG. 15. The second EVDD power line 132 and the VDD power line 133 are disposed on the insulating layer 135. The second EVDD power line 132 is in contact with the first EVDD power line 131 through a contact hole 134 that penetrates the insulating layer 135. Therefore, the first and second EVDD power lines 131 and 132 are electrically connected to each other and become equal potentials. In contrast, the VDD power line 133 can be electrically separated from the first and second EVDD power lines 131 and 132 with the insulating layer 135 interposed therebetween and thus electrically separated from the first and second EVDD power lines 131 and 132.

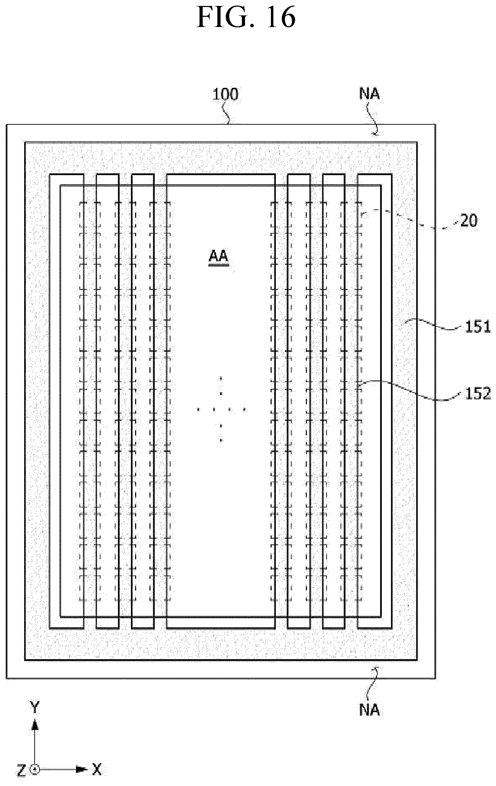

If the display panel 100 becomes larger and the resistance of the EVSS power line to which the cathode voltage EVSS is applied increases, a deviation or voltage rise in the cathode voltage EVSS can occur depending on the pixel position. To avoid this, the EVSS power line can be arranged on the display panel 100 in the structure shown in FIG. 16 (e.g., lines 151 and 152).

FIG. 16 is a plan view illustrating an example in which power lines to which a cathode voltage is applied and a compensation part of the pixel circuit are overlapped with each other.

Referring to FIG. 16, the display panel 100 can include a shorting line 151 disposed in the non-display area NA, and a plurality of EVSS power lines 152, both ends of which is connected to the shorting line 151, connected to the pixels PIX across the display area AA. For example, the shorting line 151 can extend all the way around the perimeter of the display area AA.

The EVSS power lines 152 are connected to the EVSS node of the compensation part 10 in each of the pixels. The cathode voltage EVSS is applied to the shorting line 151. Since the EVSS power lines 152 are connected to the shorting lines 151, their resistance values can be reduced. Therefore, the rise in the cathode voltage EVSS can be minimized. The EVSS power lines 152 can overlap with the mode control part 20 with the insulating layer between them. The EVSS power lines 152 overlapping with the mode control part 20 can serves as a light shielding layer to prevent the switch elements Tp and Ts from being exposed to light, which can prevent damage to the switch elements or affect their operation, and reduce reflections. When the transistors implemented as switch elements Tp and Ts are exposed to light in the off-state, the leakage current may be increased.

According to one or more embodiments of the present disclosure, the display device can be applied to mobile devices, video phones, smart watches, watch phones, wearable device, foldable device, rollable device, bendable device, flexible device, curved device, sliding device, variable device, electronic organizer, electronic books, portable multimedia players (PMPs), personal digital assistants (PDAs), MP3 players, mobile medical devices, desktop PCs, laptop PCs, netbook computers, workstations, navigations, vehicle navigations, vehicle display devices, vehicle devices, theater devices, theater display devices, televisions, wallpaper devices, signage devices, game devices, laptops, monitors, cameras, camcorders, and home appliances, etc. Additionally, the display apparatus according to one or more embodiments of the present disclosure can be applied to organic light emitting lighting devices or inorganic light emitting lighting devices.

The objects to be achieved by the present disclosure, the means for achieving the objects, and effects of the present disclosure described above do not specify essential features of the claims, and thus, the scope of the claims is not limited to the disclosure of the present disclosure.

Although the embodiments of the present disclosure have been described in more detail with reference to the accompanying drawings, the present disclosure is not limited thereto and can be embodied in many different forms without departing from the technical concept of the present disclosure. Therefore, the embodiments disclosed in the present disclosure are provided for illustrative purposes only and are not intended to limit the technical concept of the present disclosure. The scope of the technical concept of the present disclosure is not limited thereto. Therefore, it should be understood that the above-described embodiments are illustrative in all aspects and do not limit the present disclosure.

Also disclosed are the following numbered clauses:
1. A display panel comprising:
   a subpixel including a first light emitting element configured to emit a same color light with a narrow viewing angle, and a second light emitting element configured to emit the same color light with a wider viewing angle wider than the narrow viewing angle; and
   a controller configured to:
      in response to a first mode, activate the first light emitting element to emit the same color light with the narrow viewing angle, and
      in response to a second mode, activate the second light emitting element to emit the same color light with the wide viewing angle.
2. The display panel of clause 1, further comprising:
   a hemispherical shaped lens disposed over the first light emitting element; and
   a semi-cylindrical shaped lens disposed over the second light emitting element.
3. The display panel of clause 1 or 2, wherein the controller is further configured to:
   in response to the first mode, activate the first light emitting element to emit the same color light while the second light emitting element is deactivated, and
   in response to the second mode, activate both of the first light emitting element and second light emitting element to emit the same color light.
4. The display panel of clause 1, 2 or 3, wherein the controller includes at least one switching transistor having a gate electrode configured to receive a scan signal, a first electrode connected to a capacitor, and a second electrode connected to a mode selection line, and
   wherein the capacitor is connected between a first power line and the at least one switching transistor.
5. The display panel of clause 4, further comprising a second power line connected to the subpixel and configured to provide a pixel driving voltage to the subpixel,
   wherein the first power line of the controller is electrically isolated from the second power line of the subpixel.
6. The display panel of any preceding clause, further comprising:
   a plurality of subpixels including the subpixel having the first and second light emitting elements,
   wherein the controller is further configured to:
      selectively active a group of subpixels from among the plurality of subpixels to operate in the first mode to display first content with the narrow viewing angle, while a remainder of subpixels among the plurality of subpixels operate in the second mode to display second content with the wide viewing angle.
7. The display panel of any preceding clause, further comprising:
   a plurality of pixels including a plurality of subpixels including the subpixel having the first and second light emitting elements,
   wherein the controller is further configured to selectively operate the plurality of subpixels in the first mode having the narrow viewing angle or the second mode having the wide viewing angle on a pixel by pixel basis.

## Claims

1. A display panel (100) comprising:
a plurality of data lines, a plurality of gate lines, a plurality of power lines, and a plurality of pixels (PIX) disposed on a substrate,
wherein each of the plurality of pixels includes:
a first light-emitting element (EL1);
a second light-emitting element (EL2);
a compensation part (10) configured to supply a current to the first light-emitting element and the second light-emitting element;
a switch circuit configured to:
in response to receiving a mode selection signal (S_SEL, P_SEL), supply the current to the first light-emitting element in a first mode, and supply the current to the second light-emitting element in a second mode or to supply the current to both of the first light-emitting element and the second light-emitting element in the second mode; and
a mode control part (20) configured to supply the mode selection signal to the switch circuit.

2. The display panel of claim 1, wherein each of the plurality of pixels further includes a plurality of sub-pixels (SPR, SPG, SPB),
wherein each of the plurality of sub-pixels includes a first light-emitting element, a second light-emitting element, a compensation part, and a switch circuit,
wherein each switch circuit includes:
a first pixel switch element (M01) connected between the respective compensation part and the respective first light-emitting element and configured to be turned on/off in response to a first mode selection signal (P_SEL); and
a second pixel switch element (M02) connected between the respective compensation part and the respective second light-emitting element and configured to be turned on/off in response to a second mode selection signal (S_SEL),
wherein the mode control part is further configured to output the first mode selection signal and the second mode selection signal, and
wherein, in the first mode, each first light-emitting element is activated to emit light by a current supplied through its respective first pixel switch element, and
wherein, in the second mode, each second light-emitting element is activated to emit light by a current supplied through its respective second pixel switch element.

3. The display panel of claim 2, wherein the mode control part includes:
a first switch element (Tp) configured to, in response to a scan signal (SCAN), apply the first mode selection signal to a gate electrode of each first pixel switch element; and
a second switch element (Ts) configured to, in response to the scan signal, apply the second mode selection signal to a gate electrode of each second pixel switch element.

4. The display panel of claim 3, wherein the first switch element includes a first electrode connected to a first control signal line configured to receive the first mode selection signal, a gate electrode configured to receive the scan signal, and a second electrode connected to the gate electrode of the first pixel switch element, and
wherein the second switch element includes a first electrode connected to a second control signal line configured to receive the second mode selection signal, a gate electrode configured to receive the scan signal, and a second electrode connected to the gate electrode of the second pixel switch element.

5. The display panel of claim 4, wherein the mode control part further includes:
a first capacitor (Cp) connected between a power line (VDD) configured to receive a constant voltage and the second electrode of the first switch element; and
a second capacitor (Cs) connected between the power line and the second electrode of the second switch element.

6. The display panel of claim 1, wherein each of the plurality of pixels further includes a plurality of sub-pixels (SPR, SPG, SPB),
wherein each of the sub-pixels includes a first light-emitting element, a second light-emitting element, a compensation part, and a switch circuit,
wherein each switch circuit includes a pixel switch element (M) connected between the respective compensation part and the respective second light-emitting element and configured to be turned on/off in response to a second mode selection signal (S_SEL),
wherein the mode control part is further configured to output the second mode selection signal, and
wherein, in the first mode, each first light-emitting element is activated to emit light by a current from its respective compensation part, and
in the second mode, each first light-emitting element is activated to emit light by the current from its respective compensation part and each second light-emitting element is activated to emit light by a current supplied through its respective pixel switch element.

7. The display panel of claim 6, wherein the mode control part includes:
a switch element (Ts) configured to in response to a scan signal (SCAN), apply the second mode selection signal to a gate electrode of the pixel switch element.

8. The display panel of claim 7, wherein the switch element includes a first electrode connected to a control signal line configured to receive the second mode selection signal, a gate electrode configured to receive the scan signal, and a second electrode connected to the gate electrode of the pixel switch element.

9. The display panel of claim 8, wherein the mode control part further includes:
a capacitor (Cs) connected between a power line (VDD) configured to receive a constant voltage and the second electrode of the switch element.

10. The display panel of any preceding claim, wherein the display panel further includes:
a pixel driving voltage "EVDD" power line configured to supply a pixel driving voltage to the compensation part; and
a pixel driving voltage "VDD" power line configured to supply a constant voltage to the mode control part,
wherein the EVDD power line includes:
a first EVDD power line; and
a second EVDD power line connected to the first EVDD power line, and
wherein the VDD power line crosses over the second EVDD power line and the VDD power line is separated from both of the first EVDD power line and the second EVDD power line by an insulating layer.

11. The display panel of any preceding claim, wherein the display panel further includes:
a shorting line (151) disposed in a non-display area of the display panel; and
a plurality of cathode voltage "EVSS" power lines extending across a display area (AA) of the display panel, the plurality of EVSS power lines being connected to the shorting line and connected to the compensation part in each of the plurality of pixels, and
wherein the compensation part is configured to receive a cathode voltage via the shorting line and the plurality of EVSS power lines.

12. The display panel of any preceding claim, wherein the compensation part includes:
a driving element (DT) including a first electrode connected to a first node (N1), a gate electrode connected to a second node (N2), and a second electrode connected to a third node (N3);
a first compensation switch element (T1) connected between the second node and the third node and configured to be turned on in response to a first scan signal (SC1);
a second compensation switch element (T2) connected between a data line configured to receive a data voltage and the first node, and the second compensation switch element being configured to be turned on in response to a second scan signal (SC2);
a third compensation switch element (T3) connected between a power line configured to receive a pixel driving voltage and the first node, and the third compensation switch element being configured to be turned on/off in response to an emission signal;
a fourth compensation switch element (T4) connected between the third node and a fourth node (N4), and the fourth compensation switch element being configured to be turned on/off in response to the emission signal; and
a storage capacitor (Cst) connected between a power node to configured to receive the pixel driving voltage and the second node;
wherein the mode control part includes:
one or more switch elements configured to be turned on/off in response to the second scan signal.

13. The display panel of claim 12, wherein the compensation part further includes:
a fifth compensation switch element (T5) connected between the second node and an initialization power line (Vinit) configured to receive an initialization voltage, and the fifth compensation switch element being configured to be turned on/off in response to a fourth scan signal (SC4);
a sixth compensation switch element (T6) connected between a fifth node (N5) and a first compensation power line configured to receive a first compensation voltage, the sixth compensation switch element being configured to be turned on/off in response to a third scan signal (SC3);
a seventh compensation switch element (T7) connected between a sixth node (N6) and the first compensation power line, and the seventh compensation switch element being configured to be turned on/off in response to the third scan signal; and
an eighth compensation switch element (T8) connected between the first node and a second compensation power line configured to receive a second compensation voltage, and the eighth compensation switch element being configured to be turned on/off in response to the third scan signal,
wherein the switch circuit includes:
a first pixel switch element (M01) connected between the fourth node and the fifth node, and configured to be turned on to supply a current from the driving element to the first light-emitting element in the first mode; and
a second pixel switch element (M02) connected between the fourth node and the sixth node, and configured to be turned on to supply the current from the driving element to the second light-emitting element in the second mode, and
wherein the first light-emitting element includes an anode electrode connected to the fifth node, and a cathode electrode connected to a cathode power line configured to receive a cathode voltage, and
wherein the second light-emitting element includes an anode electrode connected to the sixth node, and a cathode electrode connected to the cathode power line.

14. The display panel of claim 12, wherein the compensation part further includes:
a fifth compensation switch element (T5) connected between the second node and an initialization power line (Vinit) configured to receive an initialization voltage, and the fifth compensation switch element being configured to be turned on/off in response to a fourth scan signal (SC4);
a sixth compensation switch element (T6) connected between the fourth node and a first compensation power line configured to receive a first compensation voltage, and the sixth compensation switch element being configured to be turned on/off in response to a third scan signal (SC3);
a seventh compensation switch element (T7) connected between a fifth node (N5) and the first compensation power line, and the seventh compensation switch element being configured to be turned on/off in response to the third scan signal; and
an eighth compensation switch element (T8) connected between the first node and a second compensation power line configured to receive a second compensation voltage, and the eighth compensation switch element being configured to be turned on/off in response to the third scan signal,
wherein the switch circuit includes:
a pixel switch element (M) connected between the fourth node and the fifth node, and configured to be turned on to supply a current from the driving element to the second light-emitting element in the second mode,
wherein the first light-emitting element includes an anode electrode connected to the fourth node and a cathode electrode connected to a cathode power line configured to receive a cathode voltage, and
wherein the second light emitting element includes an anode electrode connected to the fifth node and a cathode electrode connected to the cathode power line.

15. A display device comprising:
a display panel (100) according to any preceding claim;
a data driver (110) configured to supply a data voltage to the plurality of data lines; and
a gate driver (120) configured to supply a scan signal and an emission signal to the plurality of gate lines,
wherein the compensation part is configured to receive the data voltage, the scan signal, and the emission signal;
wherein the mode control part is configured to supply the mode selection signal to the switch circuit in response to the scan signal.
